# EUROPEAN PATENT APPLICATION

(11) **EP 4 106 013 A1**
(43) Date of publication of application: **21.12.2022**
(21) Application number: 20918202.1
(22) Date of filing: 14.02.2020
(51) Int. Cl.: H01L 31/0224, H01B 1/22, H01B 1/16

(54) **CONDUCTIVE PASTE FOR HETEROJUNCTION SOLAR CELL, HETEROJUNCTION SOLAR CELL, AND ELECTRODE STRUCTURE**

(71) Applicant: Giga Solar Materials Corp., Hsinchu, Taiwan, R.O.C. (TW)
(72) Inventor: CHEN, Shing-Jiun, Taiwan 30351 (TW); KUO, Huai-Jen, Taiwan 30351 (TW)
(74) Representative: Becker, Eberhard
(86) International application number: PCT/CN2020/075351
(87) International publication number: WO 2021/159499

(57) **Abstract**

The present invention provides a conductive paste for a heterojunction (HJT) solar cell, a heterojunction solar cell, and an electrode structure. The conductive paste comprises conductive particles, a polymerizable resin, and a metal salt. On the basis of the total weight of the conductive paste, the content of the conductive paste is 75 wt% to 97 wt%, the content of the polymerizable resin is 2 wt% to 20 wt%, and the content of the metal salt is 0.05 wt% to 5 wt%. The metal salt comprises a group IA metal salt, a group IIA metal salt, or a combination thereof.

## Description

### TECHNICAL FIELD

The invention relates to a conductive paste, and in particular, to a conductive paste for a heterojunction technology (HJT) solar cell, an HJT solar cell and an electrode structure.

### RELATED ART

A solar cell is a device that converts solar energy into electrical energy. The solar cell generates electrons and holes by visible light irradiating a substrate, and respectively guides the electrons and holes through positive and negative electrodes on two sides of the substrate to form currents.

An HJT solar cell is formed on a surface of the substrate with a whole surface transparent conductive oxide (TCO), and then transmits and transports currents through a hub (metal) electrode. Therefore, how to further reduce resistance of the electrode, increase electrical conductivity thereof, and reduce contact resistance between the electrode and the TCO has become an important topic of current research.

### SUMMARY OF INVENTION

The invention is directed to a conductive paste for an HJT solar cell including Group IA or Group IIA metal salts, improving electrical conductivity of an electrode manufactured from the paste, and improving adhesion between the electrode and the TCO.

The invention is also directed to an HJT solar cell, having an electrode with low resistivity and low contact resistivity, thereby improving electrical connection of the electrode and providing a solar cell with high efficiency.

The invention is further directed to an electrode structure, having excellent electrical conductivity and adhesion.

According to an embodiment of the invention, a conductive paste for an HJT solar cell includes: conductive particles of 75 wt% to 97 wt%, a polymerizable resin of 2 wt% to 20 wt%, and a metal salt of 0.05 wt% to 5 wt%. The metal salt includes a Group IA metal salt, a Group IIA metal salt, or a combination thereof.

In the conductive paste according to an embodiment of the invention, the metal salt includes an organic metal salt or an inorganic metal salt.

In the conductive paste according to an embodiment of the invention, the organic metal salt includes a saturated aliphatic metal salt or an unsaturated aliphatic metal salt.

In the conductive paste according to an embodiment of the invention, the saturated aliphatic metal salt includes cesium 2-ethylhexanoate, barium 2-ethylhexanoate, calcium 2-ethylhexanoate, cesium stearate, potassium 2-ethylhexanoate, or a combination thereof.

In the conductive paste according to an embodiment of the invention, the unsaturated aliphatic metal salt includes cesium oleate, potassium oleate, lithium oleate, sodium oleate, cesium crotonate, or a combination thereof.

In the conductive paste according to an embodiment of the invention, the inorganic metal salt includes a metal hydroxide, a metal chloride, a metal carbonate, or a combination thereof.

In the conductive paste according to an embodiment of the invention, the metal hydroxide includes lithium hydroxide, potassium hydroxide, cesium hydroxide, barium hydroxide, or a combination thereof.

In the conductive paste according to an embodiment of the invention, the metal chloride includes cesium chloride.

In the conductive paste according to an embodiment of the invention, the metal carbonate includes lithium carbonate, sodium carbonate, potassium carbonate, cesium carbonate, barium carbonate, calcium carbonate, or a combination thereof.

In the conductive paste according to an embodiment of the invention, a weight ratio of the metal salt to the polymerizable resin is 1.5 to 25.

In the conductive paste according to an embodiment of the invention, the conductive particles include silver, copper, platinum, palladium, gold, tin, indium, aluminum, bismuth, nickel, zinc, or a combination thereof.

In the conductive paste according to an embodiment of the invention, the conductive particles have an average particle size of 0.1 µm to 10 µm.

In the conductive paste according to an embodiment of the invention, the polymerizable resin includes a resin having one or more epoxy groups, a resin having a hydroxyl group, or a combination thereof.

In the conductive paste according to an embodiment of the invention, a solvent may also be included, and a content of the solvent is 1 wt% to 10 wt% based on the total weight of the conductive paste.

In the conductive paste according to an embodiment of the invention, an additive may also be included, and a content of the additive is 5 wt% or less based on the total weight of the conductive paste.

In the conductive paste according to an embodiment of the invention, the additive includes a sensitizing agent, a coupling agent, a dispersant, a levelling agent, a viscosity adjuster, a defoaming agent, a thixotropic agent, a stabilizer, a surfactant, a curing agent, a rheology additive, a resin diluent, or a combination thereof.

According to another embodiment of the invention, an HJT solar cell includes a substrate and an electrode. The substrate includes at least one transparent conductive layer. The electrode is formed on the transparent conductive layer, and the electrode is formed by curing the conductive paste described above.

According to still another embodiment of the invention, an electrode structure is formed by curing the conductive paste described above.

In the electrode structure according to still another embodiment of the invention, the electrode structure is adapted for an HJT solar cell or a touch panel, among other devices

In the electrode structure according to still another embodiment of the invention, a curing temperature is 100°C to 350°C, for example

In the electrode structure according to still another embodiment of the invention, a curing time is 1 minute to 2 hours, for example.

Based on the foregoing, since the conductive paste of the invention includes specific constituents within a specific ratio range, the resistivity of the electrode obtained by curing the conductive paste can be reduced, thereby increasing the electrical conductivity. Moreover, the contact resistance between the electrode and the transparent conductive layer can also be reduced. Besides, it is found through experiments that some conductive pastes also have the property of increasing the adhesion between the electrode and the transparent conductive layer. Accordingly, the efficiency of the HJT solar cell having the electrode with low resistivity and low contact resistivity can also be improved. Furthermore, the electrode structure may also be applied in other fields, for example, a touch panel.

### BRIEF DESCRIPTION OF THE DRAWING

The accompanying drawing is included to provide a further understanding of the invention, and is incorporated in and constitute a part of this specification. The drawing illustrates exemplary embodiments of the invention and, together with the description, serves to explain the principles of the invention.

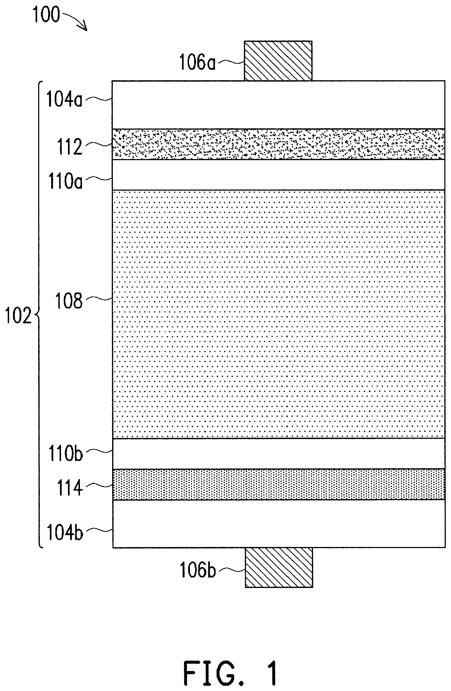

FIG. 1 is a schematic sectional view of an HJT solar cell according to an embodiment of the invention.

### Reference Signs List

100: HJT solar cell;
102: substrate;
104a, 104b: transparent conductive layer;
106a, 106b: electrode;
108: n-type monocrystalline silicon substrate;
110a, 110b: i-type amorphous silicon layer;
112: p+-type amorphous silicon layer;
114: n+-type amorphous silicon layer.

### DESCRIPTION OF THE EMBODIMENTS

Reference will now be made in detail to exemplary embodiments of the invention, examples of which are illustrated in the accompanying drawing. Wherever possible, the same reference numerals are used in the drawing and description to denote the same or like parts.

A conductive paste for an HJT solar cell includes: conductive particles of 75 wt% to 97 wt%, a polymerizable resin of 2 wt% to 20 wt%, and a metal salt of 0.05 wt% to 5 wt%. The metal salt includes a Group IA metal salt, a Group IIA metal salt, or a combination thereof. Each constituent in the conductive paste for an HJT solar cell of the invention will be described in detail below.

### <Metal salt>

In this embodiment, the metal salt includes a Group IA metal salt, a Group IIA metal salt, or a combination thereof. Therefore, metal ions in the metal salt include lithium (Li⁺), sodium (Na⁺), potassium (K⁺), rubidium (Rb⁺), cesium (Cs⁺), francium (Fr⁺), beryllium (Be²⁺), magnesium (Ma²⁺), calcium (Ca²⁺), strontium (Sr²⁺), barium (Ba²⁺), radium (Ra²⁺).

The metal salt may include an organic metal salt or an inorganic metal salt. Taking the organic metal salt as an example, the organic metal salt may include, for example but not limited to, a saturated aliphatic metal salt or an unsaturated aliphatic metal salt, and the unsaturated aliphatic metal salt further includes a monounsaturated aliphatic metal salt or a polyunsaturated aliphatic metal salt. In terms of stability of the conductive paste, a saturated aliphatic metal salt does not have a reactive functional group compared with an unsaturated aliphatic metal salt, and has more stable characteristics and a longer shelf life. The saturated aliphatic metal salt may include, for example but not limited to, sodium acetate, potassium acetate, cesium acetate, calcium acetate, barium acetate, cesium 2-ethylhexanoate, barium 2-ethylhexanoate, potassium 2-ethylhexanoate, calcium 2-ethylhexanoate, sodium palmitate, potassium palmitate, cesium palmitate, calcium palmitate, barium palmitate, cesium stearate, calcium stearate, barium stearate, sodium stearate, potassium stearate, and derivatives thereof. More specifically, the saturated aliphatic metal salt is preferably cesium 2-ethylhexanoate, barium 2-ethylhexanoate, calcium 2-ethylhexanoate, cesium stearate, potassium 2-ethylhexanoate, or a combination thereof. The unsaturated aliphatic metal salt may include, for example but not limited to, cesium oleate, potassium oleate, lithium oleate, magnesium oleate, sodium oleate, linoleic acid cesium, linoleic acid potassium, linoleic acid lithium, linoleic acid magnesium, linoleic acid sodium, α-linoleic acid cesium, α-linoleic acid potassium, α-linoleic acid lithium, α-linoleic acid magnesium, α-linoleic acid sodium, cesium crotonate, sodium crotonate, and derivatives thereof. More specifically, the unsaturated aliphatic metal salt is preferably cesium oleate, potassium oleate, lithium oleate, sodium oleate, cesium crotonate, or a combination thereof.

The inorganic metal salt may include, for example but not limited to, a metal hydroxide (MxOH), a metal chloride (M_{X}Cl), a metal carbonate (M_{X}CO₃), or a combination thereof, where M is a Group IA metal or a Group IIA metal and x is 0.5 to 2. The metal hydroxide may include, for example but not limited to, lithium hydroxide, sodium hydroxide, potassium hydroxide, rubidium hydroxide, cesium hydroxide, francium hydroxide, beryllium hydroxide, magnesium hydroxide, calcium hydroxide, strontium hydroxide, barium hydroxide, radium hydroxide, and derivatives thereof. More specifically, the metal hydroxide is preferably lithium hydroxide, potassium hydroxide, cesium hydroxide, barium hydroxide, or a combination thereof. The metal chloride may include, for example but not limited to, lithium chloride, sodium chloride, potassium chloride, rubidium chloride, cesium chloride, francium chloride, beryllium chloride, magnesium chloride, calcium chloride, strontium chloride, barium chloride, radium chloride, and derivatives thereof. More specifically, the metal chloride is preferably cesium chloride. The metal carbonate may include, for example but not limited to, lithium carbonate, sodium carbonate, potassium carbonate, rubidium carbonate, cesium carbonate, francium carbonate, beryllium carbonate, magnesium carbonate, calcium carbonate, strontium carbonate, barium carbonate, radium carbonate, and derivatives thereof. More specifically, the metal carbonate is preferably lithium carbonate, sodium carbonate, potassium carbonate, cesium carbonate, barium carbonate, calcium carbonate, or a combination thereof. The inorganic metal salt is not limited to an aqueous solution, but may also be dissolved in other solvents such as alcohols.

Moreover, the organic metal salt may be obtained by directly using a product commercially available or by mixing and reacting the inorganic metal salt with an organic acid, and may be added with a solvent at an appropriate time for mixture. In an embodiment, the organic acid may be an organic acid having 2 to 26 carbons, more preferably an organic acid having 8 to 20 carbons. The organic acid may include, for example but not limited to, palmitic acid, acetic acid, and stearic acid among saturated fatty acids; or 2-ethylhexanoic acid, oleic acid, linoleic acid, α-linolenic acid, and crotonic acid among unsaturated fatty acids.

Based on the total weight of the conductive paste, a content of the metal salt is 0.05 wt% to 5 wt%, for example, an organic metal salt 0.1 wt% to 2 wt% or an inorganic metal salt 0.05 wt% to 1 wt%. In terms of the weight ratio (i.e., PHR) of the metal salt to the polymerizable resin, the weight ratio is 1.5 to 25, for example.

### <Polymerizable resin>

In this embodiment, after the conductive paste is cured, the polymerizable resin still exists in the cured product, and may serve as an adhesive for adhering conductive particles with conductive particles and/or conductive particles with a substrate therebelow. Based on the total weight of the conductive paste, a content of the polymerizable resin is 2 wt% to 20 wt%, preferably 2.5 wt% to 10 wt%, and for example, 3 wt% to 5 wt%. To be more specific, the polymerizable resin may include, for example but not limited to, a resin having one or more epoxy groups, a resin having a hydroxyl group, or a combination thereof.

The resin having one or more epoxy groups is a thermosetting resin, and may include, for example but not limited to, bisphenol A-type epoxy resin, bisphenol F-type epoxy resin, bisphenol A novolac epoxy resin, a phenol novolac epoxy resin, o-cresol novolac epoxy resin, multifunctional epoxy resin, polyurethane-modified epoxy resin, silicon-modified epoxy resin, and may be selected from the BE series, the BFE series, the BNE series, the PNE series, the CNE series, the TFE series, and the like of Chang Chun Chemical, or selected from the NPEL series, the NPEF series, the NPPN series, the NPCN series, and the like of Nan YA Chemical if a product commercially available is to be used.

The resin having a hydroxyl group may include, for example but not limited to, polyvinyl butyral (PVB) resin, polyvinyl alcohol (PVA), polymethyl methacrylate (PMMA) resin, methyl methacrylate (MMA), phenol formaldehyde resins (PF), terpene phenolic resin, aldehyde ketone resin, and may be selected from the PVB resins of Mowital^{®}, or selected from the PF series of Chang Chun Chemical if a product commercially available is to be used. Adding a resin having a hydroxyl group increases stability and electrical conductivity of the conductive paste.

Besides, it is also possible to add resins other than the polymerizable resin, for example, a melamine resin, a urea-formaldehyde resin, a polyester resin, an alkyd resin, etc., but the invention is not limited thereto.

### <Conductive particle>

In this embodiment, the conductive particles include, for example, silver, copper, platinum, palladium, gold, tin, indium, aluminum, bismuth, nickel, zinc, or a combination thereof, and are preferably silver particles. The conductive particles have an average particle size of 0.1 µm to 10 µm, for example. The shape of the conductive particles may include a flake, a sphere, a column, a block, or a non-specific shape fitting the size. Based on the total weight of the conductive paste, a content of the conductive particles is, for example, 75 wt% to 97 wt%, and preferably 85 wt% to 95 wt%.

### <Solvent>

In this embodiment, the conductive paste may also include a solvent. In addition, a content of the solvent is, for example, 1 wt% to 10 wt% based on the total weight of the conductive paste. The solvent serves to dissolve the polymerizable resin and the metal salt for the conductive paste to be evenly mixed and have viscosity. The solvent may include, for example but not limited to, an alcohol solvent, an ether solvent, an ester solvent, or an ether alcohol solvent, for example, diethylene glycol monobutyl Ether (DB), triethylene glycol monobutyl ether (TB), butyl carbitol acetate (BCA), terpineol, texanol, butyl acetate, diethylene glycol diethyl ether, 2-butoxyethanol, or a combination thereof.

### <Additive>

In this embodiment, the conductive paste may also include an additive. The additive serves to improve the properties of the conductive paste. In addition, based on the total weight of the conductive paste, a content of the additive is 5 wt% or less, for example, and is 1 wt% to 5 wt%, for example. The additive may include, for example but not limited to, a sensitizing agent, a coupling agent, a dispersant, a levelling agent, a viscosity adjuster, a defoaming agent, a thixotropic agent, a stabilizer, a surfactant, a curing agent, a rheology additive, a resin diluent, or a combination thereof.

The coupling agent may include, for example but not limited to, a silane coupling agent including a vinyl group, an epoxy group, styrene, a methacryloxy group, an acryloxy group, an amino group, isocyanates, and may be selected from KBM-1003, KBE-1003, KBM-403, KBE-403, KBM-503, KBE-502, and the like of Shin-Etsu, or selected OFS-6300, OFS-6020, OFS-6030, OFS-6040, OFS-6011, and the like of Dow Corning if a product commercially available is to be used.

The surfactant may include, for example but not limited to, oleic acid, linoleic acid, α-linolenic acid, linseed oil, 2-ethylhexanoic acid, hydrogenated castor oil, castor oil, stearic acid, palmitic acid among fatty acids, etc.

The curing agent may include, for example but not limited to, a imidazole type curing agent, an amine type curing agent, and an anhydrides type curing agent among epoxy resin curing agents, and may be selected from 2E4MZ-CN, dicyandiamide, and the like of Shikoku Chemicals if a product commercially available is to be used.

The resin diluent may include, for example but not limited to, epoxy resin diluents such as hexanediol diglycidyl ether, etc.

FIG. 1 is a schematic cross-sectional view of an HJT solar cell according to an embodiment of the invention. Moreover, the drawing only serve for illustrative purposes, and is not drawn to the original scale.

With reference to FIG. 1, the HJT solar cell 100 includes a substrate 102 and electrodes 106a and 106b on two sides of the substrate 102. The substrate 102 takes, for example, an n-type monocrystalline silicon substrate 108 as a center, above and below which are respectively i-type amorphous silicon layers 110a and 110b. In addition, a p+-type amorphous silicon layer 112 is provided on the surface of the i-type amorphous silicon layer 110a, an n+-type amorphous silicon layer 114 is provided on the surface of the i-type amorphous silicon layer 110b, a transparent conductive layer 104a is provided on the surface of the p+-type amorphous silicon layer 112, and a transparent conductive layer 104b is provided on the surface of the n+-type amorphous silicon layer 114. Nonetheless, the invention is not limited thereto. The substrate 102 may also be composed of semiconductor materials with different conductive states or crystalline states. Alternatively, the transparent conductive layer may be disposed on only one side of the substrate 102, for example, for a back contact solar cell.

The conductive transparent layers 104a and 104b refer to thin films made of materials with excellent transparency and electrical conductivity, such as metal particles, metal nanowires, conductive polymers, or carbon materials. For specific examples, the metal particles include indium tin oxides (ITO) or other suitable materials, the metal nanowires include silver nanowires or other suitable materials, and the carbon materials include carbon nanotubes, graphene, or other suitable materials. In another embodiment, other functional film layers, for example, a passivation layer or an anti-reflection layer, may also be added between the transparent conductive layer 104a and the n-type monocrystalline silicon substrate 108 depending on requirements.

The electrodes 106a and 106b are respectively formed on the transparent conductive layers 104a and 104b. In this embodiment, the electrodes 106a and 106b are formed by curing the conductive paste in the previous embodiment. Also, a curing temperature may be about 100°C to 350°C, and preferably 150°C to 300°C. A curing time may be 1 minute to 2 hours, for example, 30 minutes to 1 hour. In addition, the curing method may include, for example but not limited to, hot air circulation-type curing or infrared curing. In the case of hot air circulation-type curing, the process parameters may be 150°C to 250°C and 20 minutes to 60 minutes. In the case of infrared curing, the process parameters may be 200°C to 300°C and 1 minute to 10 minutes.

In another embodiment, the transparent conductive layers 104a and 104b and the electrodes 106a and 106b may also be formed as an electrode structure on the surface of other devices, for example, a touch panel, etc. Since the electrodes 106a and 106b are formed by curing the conductive paste in the embodiments above, the resistivity of the electrodes 106a and 106b can be reduced, thereby increasing the electrical conductivity. Moreover, the contact resistance between the electrode 106a and the transparent conductive layer 104a and the contact resistance between the electrode 106b and the transparent conductive layer 104b may be reduced. Furthermore, it may also be likely to improve the adhesion between the electrode 106a and the transparent conductive layer 104a and the adhesion between the electrode 106b and the transparent conductive layer 104b.

Experiments are identified below to verify the effects of the invention, but the invention is not limited to the contents below.

### <Raw material>

### 1. Polymerizable resin

Polymerizable resin 1: novolac epoxy resin CNE200ELF sold from Chang Chun Chemical.
Polymerizable resin 2: linear novolac resin PF-5090 sold from Chang Chun Chemical.

### 2. Conductive particles

Conductive particle 1: flake-shaped silver powders with an average particle size of 3 µm to 5 µm
Conductive particle 2: spherical silver powders with an average particle size of 2 µm
Conductive particle 3: spherical silver powders with an average particle size of 0.8 µm to 1 µm

### 3-1. Inorganic metal salt

AQS-1: Aqueous potassium hydroxide solution of 10 wt%
AQS-2: Aqueous cesium hydroxide solution of 10 wt%
AQS-3: Aqueous barium hydroxide solution of 10 wt%
AQS-4: Aqueous potassium hydroxide solution of 22.5 wt%
AQS-5: Aqueous cesium hydroxide solution of 22.5 wt%
AQS-6: Aqueous cesium chloride solution of 0.5 wt%
AQS-7: Aqueous cesium carbonate solution of 40 wt%

3-2. Organic metal salt (if an organic metal salt below was not added with isopropyl alcohol (IPA), it was obtained by mixing with a Thinky ARM-310 planetary mixer at a rotation speed of 2000 rpm for 5 minutes; if the selected fatty acid is solid at room temperature, it was added with isopropyl alcohol to be dissolved to promote the reaction, and was stirred with a magnet at room temperature for 4 hours and then placed in a hot air circulation oven at 60°C for 48 hours to remove the isopropyl alcohol)
FAS-1: 10g of lithium carbonate + 80g of oleic acid
FAS-2: 10g of potassium carbonate + 40g oleic acid
FAS-3: 10g of cesium carbonate + 20g of oleic acid
FAS-4: 20g of cesium carbonate + 10g of oleic acid
FAS-5: 20g of cesium carbonate + 10g of stearic acid + 30g of isopropyl alcohol
FAS-6: 20g of cesium carbonate + 10g of 2-ethylhexanoic acid
FAS-7: 10g of cesium carbonate + 20g of crotonic acid + 30g of isopropyl alcohol
FAS-8: 10g of potassium carbonate + 20g of 2-ethylhexanoic acid
FAS-9: 30g of barium carbonate + 40g of 2-ethylhexanoic acid
FAS-10: 10g of calcium carbonate + 20g of 2-ethylhexanoic acid
FAS-11: Sodium oleate (97%), sold from Sigma Aldrich
FAS-12: 10g of sodium carbonate + 50g of oleic acid
FAS-13: 10g of silver acetate + 20g of stearic acid + 40g of isopropyl alcohol

### <Experimental Example>

According to the ratios in Table 1 to Table 6, the solvent, the resin, the metal salt, and the additive among the raw materials were pre-mixed by the planetary mixer, added with the conductive particles to be evenly mixed by the planetary mixer again, and then dispersed and ground by three rollers, to accordingly obtained different conductive pastes. Carbon dioxide and water that might be generated were included in calculation of the concentration of metal ions of the mixed conductive paste. Moreover, carbon dioxide and water that might be generated were included but isopropyl alcohol was not included in calculation of the concentration of metal ions of the conductor paste added with isopropyl alcohol during preparation. Therefore, the concentration of metal ions calculated according to the conditions above is slightly lower than the actual value, which is also recorded in Table 1.

**Table 1**

| Experimental Example | | Compara tive Example 1 | 1 | 2 | 3 | 4 |
|---|---|---|---|---|---|---|
| Polymerizable resin | Polymerizable resin 1 | 3.800 | 3.800 | 3.800 | 3.800 | 3.800 |
| Solvent | BCA | 2.938 | 2.938 | 2.938 | 2.938 | 2.938 |
| Conductive particle | Conductive particle 1 | 50.854 | 50.854 | 50.854 | 50.854 | 50.854 |
| | Conductive particle 2 | 4.623 | 4.623 | 4.623 | 4.623 | 4.623 |
| | Conductive particle 3 | 36.985 | 36.985 | 36.985 | 36.985 | 36.985 |
| Additive | OA | 0.800 | 0.800 | 0.800 | 0.800 | 0.800 |
| Inorganic metal salt | AQS-1 | - | 0.250 | - | - | - |
| | AQS-2 | - | - | 0.250 | - | - |
| | AQS-3 | - | - | - | 0.250 | - |
| | AQS-4 | - | - | - | - | 0.250 |
| Metal ion | | - | K⁺ | Cs⁺ | Ba²⁺ | K⁺ |
| Metal ion content (mol/g) | | 0 | 4.44E-06 | 1.66E-06 | 1.46E-06 | 1.00E-05 |
| PHR | | 0 | 6.5789 | 6.5789 | 6.5789 | 6.5789 |

In Tables 1 to 6, PHR is parts by weight of the metal salt per 100 parts by weight of the resin.

**Table 2**

| Experimental Example | | 5 | 6 | 7 | 8 | 9 |
|---|---|---|---|---|---|---|
| Polymerizable resin | Polymerizable resin 1 | 3.800 | 3.800 | 3.800 | 3.800 | 3.800 |
| | Polymerizable resin 2 | - | 0.543 | 0.543 | 0.543 | 0.543 |
| Solvent | BCA | 2.938 | 3.481 | 3.481 | 3.481 | 3.481 |
| Conductive particle | Conductive particle 1 | 50.854 | 50.854 | 50.854 | 50.854 | 50.854 |
| | Conductive particle 2 | 4.623 | 4.623 | 4.623 | 4.623 | 4.623 |
| | Conductive particle 3 | 36.985 | 36.985 | 36.985 | 36.985 | 36.985 |
| Additive | OA | 0.800 | 0.800 | 0.800 | 0.800 | 0.800 |
| Inorganic metal salt | AQS-4 | - | 0.250 | - | - | - |
| | AQS-5 | 0.250 | - | 0.250 | - | - |
| | AQS-6 | - | - | - | 0.100 | - |
| | AQS-7 | - | - | - | - | 0.250 |
| Metal ion | | Cs⁺ | K⁺ | Cs⁺ | Cs⁺ | Cs⁺ |
| Metal ion content (mol/g) | | 3.74E-06 | 9.89E-06 | 3.70E-06 | 2.93E-08 | 6.06E-06 |
| PHR | | 6.5789 | 5.7564 | 5.7564 | 2.3026 | 5.7564 |

**Table 3**

| Experimental Example | | 10 | 11 | 12 | 13 |
|---|---|---|---|---|---|
| Polymerizable resin | Polymerizable resin 1 | 2.750 | 2.750 | 2.750 | 2.750 |
| | Polymerizable resin 2 | 0.614 | 0.614 | 0.614 | 0.614 |
| Solvent | BCA | 2.785 | 2.785 | 2.785 | 2.785 |
| | Terpineol | 0.570 | 0.570 | 0.570 | 0.570 |
| Conductive particle | Conductive particle 1 | 50.727 | 50.727 | 50.727 | 50.727 |
| | Conductive particle 2 | 4.612 | 4.612 | 4.612 | 4.612 |
| | Conductive particle 3 | 36.892 | 36.892 | 36.892 | 36.892 |
| Additive | OA | 0.800 | 0.800 | 0.800 | 0.800 |
| Organic metal salt | FAS-1 | 0.250 | - | - | - |
| | FAS-2 | - | 0.250 | - | - |
| | FAS-3 | - | - | 0.250 | - |
| | FAS-4 | - | - | - | 0.250 |
| Metal ion | | Li⁺ | K⁺ | Cs⁺ | Cs⁺ |
| Metal ion content (mol/g) | | 7.52E-06 | 7.24E-06 | 5.12E-06 | 1.02E-05 |
| PHR | | 7.4316 | 7.4316 | 7.4316 | 7.4316 |

**Table 4**

| Experimental Example | | 14 | 15 | 16 | 17 | 18 |
|---|---|---|---|---|---|---|
| Polymerizable resin | Polymerizable resin 1 | 2.752 | 2.752 | 2.722 | 2.722 | 2.722 |
| | Polymerizable resin 2 | 0.613 | 0.613 | 0.545 | 0.545 | 0.545 |
| Solvent | BCA | 2.785 | 2.785 | 3.213 | 3.213 | 3.213 |
| | Terpineol | 0.570 | 0.570 | - | - | - |
| | DB | - | - | 0.270 | 0.270 | 0.270 |
| Conductive particle | Conductive particle 1 | 36.892 | 36.892 | 27.600 | 27.600 | 27.600 |
| | Conductive particle 2 | 36.892 | 36.892 | 36.800 | 36.800 | 36.800 |
| | Conductive particle 3 | 18.446 | 18.446 | 27.600 | 27.600 | 27.600 |
| Additive | OA | 0.800 | 0.800 | 1.000 | 1.000 | 1.000 |
| Organic metal salt | FAS-4 | 0.250 | - | - | - | - |
| | FAS-5 | - | 0.250 | - | - | - |
| | FAS-6 | - | - | 0.250 | - | - |
| | FAS-7 | - | - | - | 0.250 | - |
| | FAS-8 | - | - | - | - | 0.250 |
| Metal ion | | Cs⁺ | Cs⁺ | Cs⁺ | Cs⁺ | K⁺ |
| Metal ion content (mol/g) | | 1.02E-05 | 1.02E-05 | 1.02E-05 | 5.12E-06 | 1.21E-05 |
| PHR | | 7.4294 | 7.4294 | 7.6523 | 7.6523 | 7.6523 |

**Table 5**

| Experimental Example | | 19 | 20 | 21 | Comparative Example 2 |
|---|---|---|---|---|---|
| Polymerizable resin | Polymerizable resin 1 | 2.752 | 2.752 | 2.752 | 2.752 |
| | Polymerizable resin 2 | 0.613 | 0.613 | 0.613 | 0.613 |
| Solvent | BCA | 2.785 | 2.785 | 2.785 | 2.785 |
| | Terpineol | 0.570 | 0.570 | 0.570 | 0.570 |
| Conductive particle | Conductive particle 1 | 36.892 | 36.892 | 36.892 | 36.892 |
| | Conductive particle 2 | 36.892 | 36.892 | 36.892 | 36.892 |
| | Conductive particle 3 | 18.446 | 18.446 | 18.446 | 18.446 |
| Additive | OA | 0.800 | 0.800 | 0.800 | 0.800 |
| Organic metal salt | FAS-10 | 0.250 | - | - | - |
| | FAS-11 | - | 0.250 | - | - |
| | FAS-12 | - | - | 0.250 | - |
| | FAS-13 | - | - | - | 0.250 |
| Metal ion | | Ca²⁺ | Na⁺ | Na⁺ | Ag⁺ |
| Metal ion content (mol/g) | | 8.33E-06 | 8.21E-06 | 7.86E-06 | 4.99E-06 |
| PHR | | 7.4294 | 7.4294 | 7.4294 | 7.4294 |

**Table 6**

| Experimental Example | | 22 | 23 | 24 | 25 |
|---|---|---|---|---|---|
| Polymerizable resin | Polymerizable resin 1 | 2.722 | 2.722 | 2.722 | 2.722 |
| | Polymerizable resin 2 | 0.545 | 0.545 | 0.545 | 0.545 |
| Solvent | BCA | 2.733 | 2.733 | 2.733 | 2.733 |
| | DB | 1.000 | 1.000 | 1.000 | 1.000 |
| Conductive particle | Conductive particle 1 | 18.400 | 18.400 | 18.400 | 18.400 |
| | Conductive particle 2 | 46.000 | 46.000 | 46.000 | 46.000 |
| | Conductive particle 3 | 27.600 | 27.600 | 27.600 | 27.600 |
| Additive | 2-Ethylhexanoic acid | 0.700 | 0.700 | 0.700 | 0.700 |
| Organic metal salt | FAS-6 | 0.300 | 0.600 | - | - |
| | FAS-9 | - | - | 0.300 | 0.600 |
| Metal ion | | Cs⁺ | Cs⁺ | Ba²⁺ | Ba²⁺ |
| Metal ion content (mol/g) | | 1.23E-05 | 2.45E-05 | 6.51E-06 | 1.30E-05 |
| PHR | | 9.1827 | 18.3655 | 9.1827 | 18.3655 |

### <Electrical Analysis>

The conductive pastes prepared by the Experimental Examples above were screenprinted on a monocrystalline silicon wafer substrate with a surface of SiNx, dried, and then cured with hot air circulation at a temperature of 200°C for 30 minutes to obtain a thin wire electrode. For the pattern specification of the thin wire electrode, the middle segment has a width of 50 µm and a length of 4.6 cm, and the size of the head/tail contact pad is 2 mm×2 mm. Then, the resistance of the thin wire electrode was measured using the HIOKI 3540 micro-resistance meter, and the cross-sectional area of the thin wire electrode was measured using the Zeta 20 3D stereoscopic microscope, so as to obtain the resistivity (p) from Formula: "resistivity = resistance of thin wire electrode × cross-sectional area of thin wire electrode ÷ length of thin wire electrode", which is recorded in Table 7 below.

In addition, the conductive pastes prepared by the Experimental Examples above were coated on a TCO of a substrate, dried, and then cured with hot air circulation at a temperature of 200°C for 30 minutes to obtain an electrode pattern. The electrode pattern is composed of five linear-shaped electrodes with a line width of 0.7 mm and a length of 40 mm, where a line spacing is 3.3 mm. Then, after the resistance between linear electrodes with different spacings was measured with the HIOKI 3540 micro-resistance meter, the contact resistivity (pC) with the substrate was obtained by the transmission line modeling method (TLM) with the combination of the resistance value and the distance between the linear electrodes, and is recorded in Table 7 below. Since values of the contact resistivity differ with the sizes and spacings of the test patterns, relative values instead of actual values are intended to be presented here.

### <Adhesion Analysis>

The conductive pastes prepared by the Experimental Examples above were coated on the substrate, dried, and then cured with hot air circulation at a temperature of 200°C for 30 minutes to obtain a test electrode. For the pattern specification of the test electrode, the length is 5 cm and the width is 0.2 cm. Then, a tin-copper plating solder strip with a width of 0.9 mm was soldered to the test electrode. The substrate was fixed on a platform of a tensile force gauge for peel strength testing. The model of the tensile force gauge is the AIKOH RX-20 electronic push-pull force gauge. The test conditions were peeling off the solder strip at an angle of 180° and a speed of 300 mm/min to obtain values of the tensile force, with one value recorded every 0.2 seconds. The obtained tensile force is the average value of an electrode with a length of 5 cm, and the results are also reported in Table 7 below. The value of the obtained tensile force being greater than the minimum test value (0.1N) of the tensile force gauge is presented by the measured value. The average peeling strength, during the tensile force test where the solder strip was not peeled off directly, being less than the minimum test value of the tensile force gauge is indicated by "⁺". The case where the solder strip was entirely peeled off upon being pulled is indicated by "-".

**Table 7**

| Experimental Example | ρ | | ρC | | Adhesion |
|---|---|---|---|---|---|
| | (Ω·cm) | Normalized | (Ω·cm) | Normalized | (N/mm) |
| Comparative Example 1 | 5.52E-05 | 100% | 2.35E+00 | 100% | - |
| 1 | 6.51E-06 | 12% | 4.00E-01 | 17% | + |
| 2 | 6.61E-06 | 12% | 4.11E-01 | 17% | + |
| 3 | 2.24E-05 | 41% | 6.80E-01 | 29% | + |
| 4 | 6.19E-06 | 11% | 4.24E-01 | 18% | + |
| 5 | 6.31E-06 | 11% | 1.34E-01 | 6% | + |
| 6 | 6.95E-06 | 13% | 4.65E-01 | 20% | + |
| 7 | 7.43E-06 | 13% | 4.24E-01 | 18% | 1.014 |
| 8 | 3.46E-05 | 63% | 5.00E-01 | 21% | + |
| 9 | 6.86E-06 | 12% | 6.73E-01 | 29% | 0.100 |
| 10 | 3.53E-05 | 64% | 6.23E-01 | 27% | + |
| 11 | 6.94E-06 | 13% | 4.33E-01 | 18% | 0.661 |
| 12 | 5.30E-06 | 10% | 4.12E-01 | 18% | 1.082 |
| 13 | 8.14E-06 | 15% | 3.96E-01 | 17% | 0.467 |
| 14 | 6.40E-06 | 12% | 5.09E-01 | 22% | 0.401 |
| 15 | 6.58E-06 | 12% | 4.48E-01 | 19% | 0.427 |
| 16 | 5.07E-06 | 9% | 4.54E-01 | 19% | 0.366 |
| 17 | 5.43E-06 | 10% | 4.66E-01 | 20% | 0.953 |
| 18 | 6.14E-06 | 11% | 4.87E-01 | 21% | 0.438 |
| 19 | 1.19E-05 | 22% | 3.55E-01 | 15% | + |
| 20 | 7.89E-06 | 14% | 4.43E-01 | 19% | + |
| 21 | 6.91E-06 | 13% | 3.76E-01 | 16% | + |
| 22 | 7.00E-06 | 13% | 3.97E-01 | 17% | 0.898 |
| 23 | 1.53E-05 | 28% | 4.23E-01 | 18% | 0.379 |
| 24 | 1.19E-05 | 22% | 9.14E-01 | 39% | 0.173 |
| 25 | 1.70E-05 | 31% | 1.05E+00 | 45% | 0.242 |
| Comparative Example 2 | 1.44E-05 | 26% | - | - | - |

The degree of contact resistivity of Comparative Example 2 could not be measured due to its extremely poor adhesion to the ITO.

As can be seen from Table 7, compared with the conductive paste without a metal salt or containing a metal salt of other groups, the resistivity (p) and contact resistivity (pC) of the conductive paste containing a Group IA metal salt or a Group IIA metal salt are obviously reduced, and the adhesion of the electrode manufactured by some conductive pastes containing Group IA or IIA metal salts can even be increased.

### <HJT solar cell efficiency>

A 6-inch N-type HJT solar substrate was manufactured by coating the conductive pastes of Experimental Examples 14 and 17 on the surface of the ITO layer and curing the conductive pastes with hot air circulation at a temperature of 200°C and a time of 0.5 hour to form electrodes on the surface of the substrate. The front electrode is composed of five busbars with a width of 0.7 mm and 101 fingers with a width of 28 µm. The back electrode is composed of five busbars with a width of 0.9 mm and 180 fingers with a width of 70 µm.

Then, a photoelectric conversion efficiency test was performed, and the measured results of open circuit voltage (Voc), short circuit current (ISC), fill factor (FF), and photoelectric conversion efficiency (NCell) are recorded in Table 8 below.

**Table 8**

| Conductive paste | V_{OC} (V) | I_{SC} (A) | FF (%) | NCell |
|---|---|---|---|---|
| Experimental Example 14 | 0.7371 | 9.2944 | 81.73 | 22.92% |
| Experimental Example 17 | 0.7379 | 9.3321 | 82.06 | 23.13% |

As can be seen from Table 8, the conductive paste of the invention results in a high open circuit voltage, a high short circuit current, a high fill factor, and a high photoelectric conversion efficiency of the HJT solar cell.

In summary of the foregoing, the invention provides a conductive paste for an HJT solar cell, which includes constituents within a specific content range. Therefore, forming the conductive paste on the surface of the transparent conductive layer improves the electrical properties of the electrode structure, thereby enhancing the photoelectric conversion efficiency of the HJT solar cell.

Finally, it should be noted that the embodiments above only serve for describing, instead of limiting, the technical solutions of the invention. Although the invention has been described in detail with reference to the embodiments above, those of ordinary skill in the art should understand that modification to the technical solutions recited in the embodiments above, or equivalent substitution of some or all of the technical features therein may be performed. The nature of the corresponding technical solutions so modified or substituted does not depart from the scope of the technical solutions of the embodiments of the invention.

## Claims

1. A conductive paste for a heterojunction solar cell, comprising:
conductive particles of 75 wt% to 97 wt%;
a polymerizable resin of 2 wt% to 20 wt%; and
a metal salt of 0.05 wt% to 5 wt%, comprising a Group IA metal salt, a Group IIA metal salt, or a combination thereof.

2. The conductive paste for a heterojunction solar cell according to claim 1, wherein the metal salt comprises an organic metal salt or an inorganic metal salt.

3. The conductive paste for a heterojunction solar cell according to claim 2, wherein the organic metal salt comprises a saturated aliphatic metal salt or an unsaturated aliphatic metal salt.

4. The conductive paste for a heterojunction solar cell according to claim 3, wherein the saturated aliphatic metal salt comprises cesium 2-ethylhexanoate, barium 2-ethylhexanoate, calcium 2-ethylhexanoate, cesium stearate, potassium 2-ethylhexanoate, or a combination thereof.

5. The conductive paste for a heterojunction solar cell according to claim 3, wherein the unsaturated aliphatic metal salt comprises cesium oleate, potassium oleate, lithium oleate, sodium oleate, cesium crotonate, or a combination thereof.

6. The conductive paste for a heterojunction solar cell according to claim 2, wherein the inorganic metal salt comprises a metal hydroxide, a metal chloride, a metal carbonate, or a combination thereof.

7. The conductive paste for a heterojunction solar cell according to claim 6, wherein the metal hydroxide comprises lithium hydroxide, potassium hydroxide, cesium hydroxide, barium hydroxide, or a combination thereof.

8. The conductive paste for a heterojunction solar cell according to claim 6, wherein the metal chloride comprises cesium chloride.

9. The conductive paste for a heterojunction solar cell according to claim 6, wherein the metal carbonate comprises lithium carbonate, sodium carbonate, potassium carbonate, cesium carbonate, barium carbonate, calcium carbonate, or a combination thereof.

10. The conductive paste for a heterojunction solar cell according to claim 1, wherein a weight ratio of the metal salt to the polymerizable resin is 1.5 to 25.

11. The conductive paste for a heterojunction solar cell according to claim 1, wherein the conductive particles comprise silver, copper, platinum, palladium, gold, tin, indium, aluminum, bismuth, nickel, zinc, or a combination thereof.

12. The conductive paste for a heterojunction solar cell according to claim 1, wherein the conductive particles have an average particle size of 0.1 µm to 10 µm.

13. The conductive paste for a heterojunction solar cell according to claim 1, wherein the polymerizable resin comprises a resin having one or more epoxy groups, a resin having a hydroxyl group, or a combination thereof.

14. The conductive paste for a heterojunction solar cell according to claim 1, further comprising a solvent, and a content of the solvent is 1 wt% to 10 wt% based on the total weight of the conductive paste.

15. The conductive paste for a heterojunction solar cell according to claim 1, further comprising an additive, and a content of the additive is 5 wt% or less based on the total weight of the conductive paste.

16. The conductive paste for a heterojunction solar cell according to claim 15, wherein the additive comprises a sensitizing agent, a coupling agent, a dispersant, a levelling agent, a viscosity adjuster, a defoaming agent, a thixotropic agent, a stabilizer, a surfactant, a curing agent, a rheology additive, a resin diluent, or a combination thereof.

17. A heterojunction solar cell, comprising:
a substrate, comprising at least one transparent conductive layer; and
an electrode, formed on the transparent conductive layer, and the electrode being formed by curing the conductive paste according to any one of claims 1 to 16.

18. The heterojunction solar cell according to claim 17, wherein a curing temperature is 100°C to 350°C.

19. The heterojunction solar cell according to claim 17, wherein a curing time is 1 minute to 2 hours.

20. An electrode structure, formed by curing the conductive paste according to any one of claims 1 to 16.

21. The electrode structure according to claim 20, being adapted for an heterojunction solar cell or a touch panel.

22. The electrode structure according to claim 20, wherein a curing temperature is 100°C to 350°C.

23. The electrode structure according to claim 20, wherein a curing time is 1 minute to 2 hours.
